# EUROPEAN PATENT APPLICATION

(11) **EP 1 515 430 A1**
(43) Date of publication of application: **16.03.2005**
(21) Application number: 03103387.1
(22) Date of filing: 15.09.2003
(51) Int. Cl.: H03D 7/16, H03D 1/22

(54) **Mixer for the conversion of radio frequency signals into baseband signals**

(71) Applicant: IEE INTERNATIONAL ELECTRONICS & ENGINEERING S.A., 6468 Echternach (LU)
(72) Inventor: Lamesch, Laurent, 4881 Lamadelaine (LU)
(74) Representative: Beissel, Jean

(57) **Abstract**

The invention relates to a mixer for converting a radio frequency input signal (1) to a baseband output signal (2, 3) comprising
- a number N of input switching means (21, 22, 23, ..., 29) for sampling the radio frequency input signal (1),
- a number N of integrator means (31, 32, 33, ..., 39) for integrating the output signals of the input switching means (21, 22, 23, ..., 29),
- a switch controller (10) for controlling the input switching means (21, 22, 23, ..., 29), and
- at least one summing means (41, 42, 43, ..., 49, 51, 52, 53, ..., 59, 60, 70) for calculating a weighted sum (2, 3) of the integrator means output signals.

## Description

### Field of the invention

The present invention relates to a mixer, which is especially applicable for the conversion of radio frequency signals into baseband signals.

### Background of the invention

A mixer is a circuit for frequency conversion of a signal. Mixers are preferably applied in transmitter and receiver circuits and belong to the essential components of wireless transmission systems besides amplifiers and filters. In the art, two different kinds of mixers are distinguished: upconversion and downconversion mixers. An upconversion-mixer converts a signal with a low frequency into a signal with a high frequency, preferably a carrier frequency. The downconversion mixer works vice versa.

In a wireless transmission system, a signal is converted into a radio frequency signal with a carrier frequency sufficient for wireless transmission. On the receiving side of such a system, the radio frequency signal is down converted, i.e., it is converted from the frequency domain of the carrier frequency into a low frequency domain for further processing in a receiver circuit. Preferably, the radio frequency signal is directly converted into a baseband signal, i.e., into a frequency domain suitable for further processing without further frequency conversion steps.

In mixer design, two goals are fundamental for achieving a good signal quality at low costs. First, only the signal with the fundamental carrier frequency should be converted to the baseband, and not the signals with the higher harmonics of the carrier frequency. Second, the complexity of the radio frequency portion of the mixer should be kept as small as possible. Both goals appear to be contradictory, since a good signal quality typically requires high expenses in signal processing circuitry.

Switching mixers appear to be a good compromise between signal quality and costs. They are multiplying mixers, i.e., they multiply an input signal with a local signal in order to achieve a desired output signal in the baseband. The multiplication is implemented with switches controlled by a square wave signal. However, such mixers also convert a lot of the higher harmonics of the carrier frequency into the baseband signal. In order to improve signal quality, switching mixers known from prior art with low complexity on the receiving or radio frequency side only attenuate the harmonics of the carrier frequency to a certain degree.

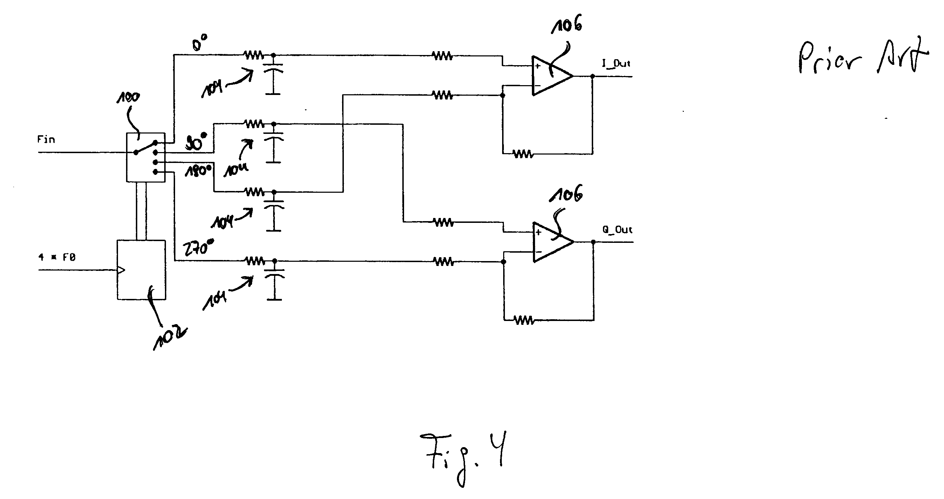

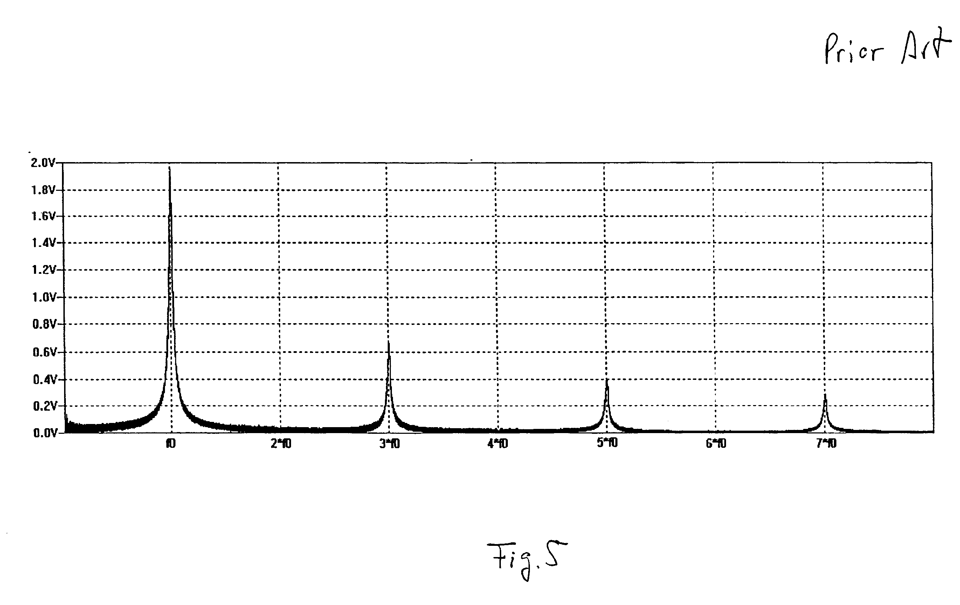

US 6,230,000 discloses a direct conversion receiver or mixer which samples an input signal waveform four times per period and then integrates the samples over time to produce an average voltage at 0, 90, 180, and 270 degrees. An embodiment of this known mixer is shown in Fig. 4. An input signal Fᵢₙ is sampled with a multiplexer switch 100 four times per period. A control circuit 102 receives a clock signal with a frequency equal to four times of the frequency F₀ of the input signal Fᵢₙ and generates control signals for controlling the switch 100. According to these control signals, switch 100 produces four output sample signals at phases of 0, 90, 180, and 270 degrees. The four output sample signals are then integrated by respective integrators 104 each consisting of a resistor and a capacitor. The integrated signals are finally summed by operational amplifiers 106 in order to achieve a quadrature signal component Q_out and an in-phase signal component I_out of the desired baseband signal. This switching mixer is able to suppress the harmonics of the carrier frequency of the input signal to a certain degree, as can be seen from Fig. 5.

### Object of the invention

It is an object of the present invention to provide a mixer with an improved quality of its output signal. This object is achieved with a mixer as claimed in claim 1.

### Summary of the invention

According to an essential aspect of the invention, the number of switches used in a switching mixer is increased and summing means with weighted input gains are used, particularly with weights which are substantially proportional to a sine respectively to a cosine function. The benefit is that, if N switches and integrators are used, the 2^{nd} to N-2^{nd} harmonics are substantially suppressed.

The present invention relates to mixer for converting a radio frequency input signal to a baseband output signal comprising
- a number N of input switching means for sampling the radio frequency input signal,
- a number N of integrator means for integrating the output signals of the input switching means,
- a switch controller for controlling the input switching means, and
- at least one summing means for calculating a weighted sum of the integrator means output signals.

In a preferred embodiment of the mixer, at least two summing means are provided wherein a first summing means is provided for producing an in-phase component of the baseband output signal and a second summing means is provided for producing a quadrature component of the baseband output signal.

The weights of the inputs of the first summing means are preferably chosen to be substantially proportional to the amplitudes of the samples of a sine wave, wherein the samples are substantially evenly distributed over the sine wave period.

The weights of the inputs of the second summing means are preferably chosen to be substantially proportional to the amplitudes of the samples of a cosine wave, wherein the samples are substantially evenly distributed over the cosine wave period.

Each one of the integrator means can be designed to integrate the radio frequency input signal over a fixed interval of the carrier period of the radio frequency input signal.

The radio frequency input signal is preferably connected to the inputs of the N integrator means by means of the N switching means.

In a preferred embodiment, each one of the N integrator means is designed so that the integrating interval is substantially the same for each one of the integrator means and the starting points of the integrating intervals are substantially evenly distributed over the carrier period of the radio frequency input signal.

For example, N can be set to 8 and the switch controller is in that case driven by a signal with a frequency of eight times of the carrier frequency of the radio frequency input signal.

The switching means can be analog switches or discrete transistors, and the switch controller can be a digital ring counter, or the switching means can be implemented by an analog multiplexer and the switch controller can be a binary counter driving the multiplexer through its selection inputs.

The integrator means can be passive resistor-capacitor integrators or active integrators based on operational amplifiers.

### Brief description of the drawings

The present invention will now be described, by way of example, with reference to the accompanying drawings, in which:
Fig. 1 shows a first embodiment of a mixer according to the present invention;
Fig. 2 shows a second embodiment of a mixer according to the present invention, wherein N = 8;
Fig. 3 shows a diagram of the frequency spectrum of an output signal produced by a mixer according to the invention;
Fig. 4 shows a mixer known from prior art; and
Fig. 5 shows a diagram of the frequency spectrum of an output signal produced by the mixer from Fig. 4.

### Detailed description of preferred embodiments

Preferred embodiments of a mixer in accordance with the invention will now be described. In the present embodiments, the mixer is designed to be used in a direct conversion circuitry for radio frequency signals.

In the following description the same and/or equal and/or similar elements can be denoted with the same reference numerals.

Fig. I shows a mixer for converting a radio frequency input signal into a baseband output signal, to be more concrete, into an in-phase component of the baseband output signal and a quadrature component of the baseband output signal. The mixer comprises an input 1 for a radio frequency signal, a switch controller 10 with an input 4, N switching means 21, 22, 23, ..., 29, N integrator means 31, 32, 33, ..., 39, two summing means comprising 2*N weighting amplifiers 41, 42, 43, ..., 49, 51, 52, 53, ..., 59 and two summing amplifiers 60 and 70, an in-phase component output 2, and a quadrature component output 3.

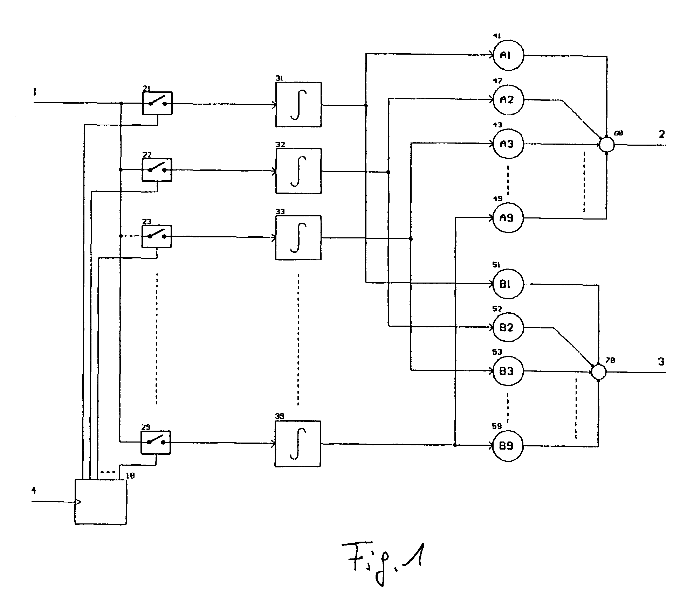

The radio frequency input signal enters the mixer circuit at input 1 and is selectively transferred to the input of the N integrator means 31, 32, 33, ..., 39. The input 4 of the switch controller 10 is driven by a periodic signal with a frequency equal to about N times of the carrier frequency fl of the radio frequency input signal. The switch controller 10 divides the input frequency N*f1 at input 4 by N, and controls the switching action of the switching means 21, 22, 23, ..., 29 with this divided frequency, wherein the phase shift in degrees between two consecutive switching means is 360/N. In Fig. 1, only 4 of the N integrator and switching means are shown.

The switching means 21, 22, 23, ..., 29 are preferably analog switches or discrete transistors, and the switch controller 10 is preferably a digital ring counter. The switching means 21, 22, 23, ..., 29 can also be replaced by an analog multiplexer, in this case the switch controller 10 is a binary counter driving the multiplexer through its selection inputs.

The integrator means 31, 32, 33, ..., 39 can be passive resistor-capacitor integrators or active integrators based on operational amplifiers. In the case of active integrators, it is clear that means must be provided to prevent saturation of the integrator outputs, either by periodically resetting the integrator or by providing a continuous discharge path.

The outputs of the integrator means 31, 32, 33, ..., 39 are on one side weighted (multiplied) with the weights A1, A2, A3, ..., A9 by the weighting amplifiers 41, 42, 43, ..., 49 and on the other side multiplied with weights B1, B2, B3, ..., B9 by the weighting amplifiers 51, 52, 53, ..., 59. The weights A1, A2, A3, ..., A9 are substantially proportional to the amplitudes of the samples of a sine wave wherein the samples are substantially evenly distributed over the sine wave period, and the weights B1, B2, B3, ..., B9 are substantially proportional to the amplitudes of the samples of a cosine wave wherein the samples are substantially evenly distributed over the cosine wave period.

The outputs of the weighting amplifiers 41, 42, 43, ..., 49 and 51, 52, 53, ..., 59 are summed together with the summing amplifiers 60 and 70, respectively. Summing amplifier 60 produces the relative in-phase component of the baseband signal provided at output 2 of the mixer, and summing amplifier 70 produces the relative quadrature component of the baseband signal provided at output 3 of the mixer. If only one output of the mixer is used in an application, then the devices necessary to produce the other output are not required.

In an embodiment of the invention, the weighting amplifiers 41, 42, 43, ..., 49 and summing amplifier 60, respectively 51, 52, 53, ..., 59 and 70 are preferably integrated into a single weighting summing amplifier which can be an operational amplifier connected as difference amplifier with multiple inputs, wherein the resistors defining the gains for each input are scaled according to the required weights.

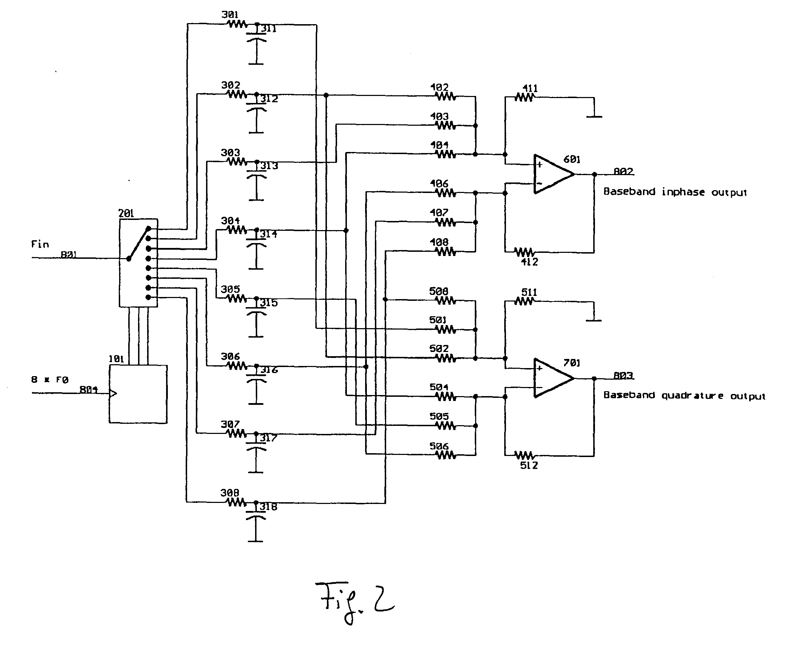

Fig. 2 shows an embodiment of the mixer according to the invention with N=8. Here, the switching means are integrated into a single multiplexer 801, and the switch controller is implemented by a digital counter 101 driven by a signal 804 with a frequency of 8*FO. The integrator devices are passive resistor-capacitor (RC) circuits with resistors 301, 302, 303, 304, 305, 306, 307, 308 and capacitors 311, 312, 313, 314, 315, 316, 317, 318, and the weighting amplifiers and summing amplifiers are each integrated into a difference amplifier consisting of an operational amplifier 601 and 701 respectively, with their associated gain-defining resistors 402, 403, 404, 406, 407, 408, 411, 412 and 500, 501, 502, 504, 505, 506 respectively. As for N=8 and for this embodiment, the first weight of the in phase output 802 is sin(0*360/8)=0 (angle in degrees) and the fourth weight of the in phase output 802 is sin(4*360/8)=0, the output of the integrators 301, 311 and 305, 315 are not connected to an input of the in phase difference amplifier. Similarly, the outputs of integrators 303, 313 and 307, 317 are not connected to the quadrature difference amplifier.

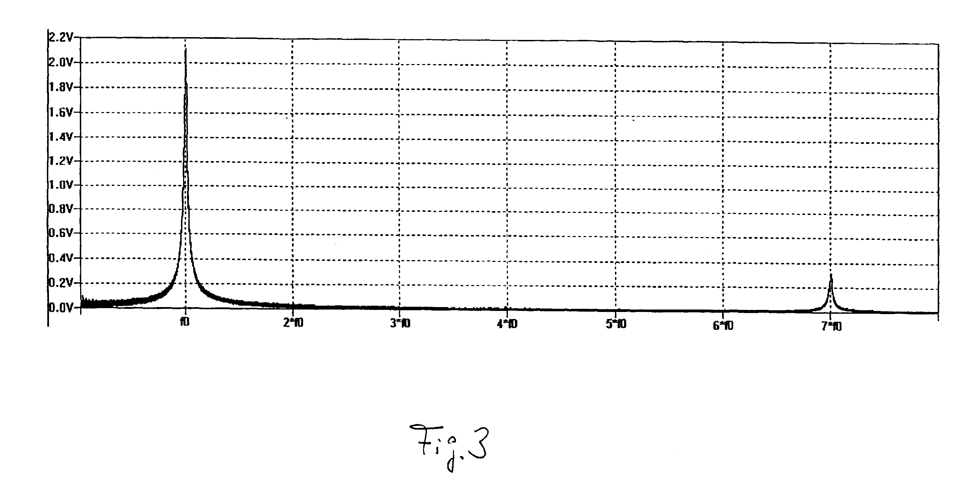

Fig. 3 shows the performance of the circuit in Fig. 2, the 2^{nd} to N-2^{nd} harmonics of the input signal are suppressed. The benefit of the invention can be seen in the comparison of Fig. 5, which shows no suppression of the harmonics 3*f0 and 5*f0 of an embodiment of the prior art shown in Fig. 4, and Fig. 3 which shows the suppression of the harmonics, in this case 2*fO to 6*fO, of an embodiment of the invention.

### Reference numerals

- 1: mixer input
- 2: in-phase component output of the mixer
- 3: quadrature component output of the mixer
- 4: switch controller input
- 10: switch controller
- 21, 22, 23, ..., 29: input switching means
- 31, 32, 33, ..., 39: integrator means
- 41, 42, 43, ..., 49: weighting amplifiers
- 51, 52, 53, ..., 59: weighting amplifiers
- 60: summing amplifier
- 70: summing amplifier
- 100: multiplexer switch
- 101: digital counter
- 102: control circuit
- 104: integrator
- 106: operational amplifier
- 201: multiplexer
- 301, ..., 308: resistors
- 311, ..., 318: capacitors
- 402, ..., 404: weighting resistors
- 406, ..., 408: weighting resistors
- 411,412: resistors
- 500,501,502: weighting resistors
- 504, ..., 506: weighting resistors
- 511, 512: resistors
- 601,701: operational amplifiers
- 801: mixer input
- 802: baseband inphase output
- 803: baseband quadrature output
- 804: switch controller input

## Claims

1. A mixer for converting a radio frequency input signal (1) to a baseband output signal (2, 3) comprising
- a number N of input switching means (21, 22, 23, ..., 29) for sampling the radio frequency input signal (1),
- a number N of integrator means (31, 32, 33, ..., 39) for integrating the output signals of the input switching means (21, 22, 23, ..., 29),
- a switch controller (10) for controlling the input switching means (21, 22, 23, ..., 29), and
- at least one summing means (41, 42, 43, ..., 49, 51, 52, 53, ..., 59, 60, 70) for calculating a weighted sum (2, 3) of the integrator means output signals.

2. The mixer according to claim 1, **characterized by** at least two summing means (41, 42, 43, ..., 49, 51, 52, 53, ..., 59, 60, 70) wherein a first summing means (41, 42, 43, ..., 49, 60) is provided for producing an in-phase component (2) of the baseband output signal and a second summing means (51, 52, 53, ..., 59, 70) is provided for producing a quadrature component (3) of the baseband output signal.

3. The mixer according to claim 2, **characterized in that** the weights (41, 42, 43, ..., 49) of the inputs of the first summing means (60) are chosen to be substantially proportional to the amplitudes of the samples of a sine wave, wherein the samples are substantially evenly distributed over the sine wave period.

4. The mixer according to claim 2 or 3, **characterized in that** the weights (51, 52, 53, ..., 59) of the inputs of the second summing means (70) are chosen to be substantially proportional to the amplitudes of the samples of a cosine wave, wherein the samples are substantially evenly distributed over the cosine wave period.

5. The mixer according to any of the preceding claims, **characterized in that** each one of the integrator means (31, 32, 33, ..., 39) is designed to integrate the radio frequency input signal (1) over a fixed interval of the carrier period of the radio frequency input signal (1).

6. The mixer according to any of the preceding claims, **characterized in that** the radio frequency input signal (1) is connected to the inputs of the N integrator means (31, 32, 33, ..., 39) by means of the N switching means (21, 22, 23, ..., 29).

7. The mixer according to any of the preceding claims, **characterized in that** each one of the N integrator means (31, 32, 33, ..., 39) is designed so that the integrating interval is substantially the same for each one of the integrator means (31, 32, 33, ..., 39) and the starting points of the integrating intervals are substantially evenly distributed over the carrier period of the radio frequency input signal (1).

8. The mixer according to any of the preceding claims, **characterized in that** the switching means (21, 22, 23, ..., 29) are analog switches or discrete transistors, and the switch controller (10) is a digital ring counter, or the switching means (21, 22, 23, ..., 29) are implemented by an analog multiplexer and the switch controller (101) is a binary counter driving the multiplexer through its selection inputs.

9. The mixer according to any of the preceding claims, **characterized in that** the integrator means (31, 32, 33, ..., 39) are passive resistor-capacitor integrators or active integrators based on operational amplifiers.
